# EUROPÄISCHE PATENTSCHRIFT

(11) **EP 0 385 283 B1**
(45) Veröffentlichungstag und Bekanntmachung des Hinweises auf die Patenterteilung: **08.12.1993**
(21) Anmeldenummer: 90103488.4
(22) Anmeldetag: 23.02.1990
(51) Int. Cl.: C23C 28/04, C23C 14/06, C23C 16/26, C23C 14/32

(54) **Verfahren zur Beschichtung von Hartmetallgrundkörpern und Hartmetallwerkzeug hergestellt nach dem Verfahren**
Process for coating hard metal substrates, and hard metal tool produced by the process
Procédé de revêtement d'un substrat en métal dur et outil en métal dur produit par ce procédé

(30) Priorität: 03.03.1989 DE 3906881
(43) Veröffentlichungstag der Anmeldung: 05.09.1990
(73) Patentinhaber: BALZERS AKTIENGESELLSCHAFT, 9496 Balzers (LI)
(72) Erfinder: Bergmann, Erich, Dr., CH-887 Mels (CH); Rudigier, Helmut, Dr., CH-7310 Bad-Ragaz (CH)
(74) Vertreter: Keller, René, Dr.

(56) Entgegenhaltungen:
- EP-A- 0 166 708

## Beschreibung

Die Erfindung betrifft ein Verfahren zur Beschichtung von Hartmetallgrundkörpern, gemäß dem Oberbegriff des Patentanspruchs 1, sowie ein Hartmetallwerkzeug, insbesondere ein Schneidwerkzeug oder Trennwerkzeug (Werkzeug für die spanende Bearbeitung), hergestellt nach dem Verfahren gemäß dem Oberbegriff des Patentanspruchs 10.

Verfahren dieser Art, bei denen die Unterschicht durch einen PVD-Prozeß und die Oberschicht durch einen CVD-Prozeß aufgebracht wird (PVD/CVD-Verfahren), sind zu unterscheiden von jenen altbekannten Verfahren anderer Art, bei denen sowohl die Unter- als auch die Oberschicht durch einen CVD-Prozeß aufgebracht wird (CVD/CVD-Verfahren).

Ein Verfahren der eingangs genannten Art ist aus der DE-OS 35 15 919 bekannt. Wie in der Beschreibungseinleitung der DE-OS 35 15 919 mit Bezug auf die CH-PS 542 678 erläutert, ließen sich mit den CVD/CVD-Verfahren, bei denen man stets darauf geachtet hat, daß die Härte der (metallischen) Unterschicht größer als diejenige des Hartmetallgrundkörpers und kleiner als diejenige der Hartstoff-Oberschicht ist, nicht die Verschleißeigenschaften erzielen, die für eine Verwendung der beschichteten Hartmetallkörper als Werkzeug für die spanende und spanlose Formgebung von metallischen Werkstücken erforderlich sind (Seite 4, Zeile 5 - Seite 5, Zeile 14 der DE-OS). Die DE-OS 35 15 919 lehrt nun demgegenüber, daß sich die für die spanende und spanlose Formgebung von metallischen Werkstücken erforderlichen Verschleißeigenschaften erzielen lassen, indem eine metallische Unterschicht aus Molybdän und/oder Wolfram auf den Hartmetallgrundkörper durch direkte Kathodenzerstäubung (ein PVD-Prozeß) und eine metallfreie Oberschicht aus einem Hartstoff (Titankarbid, Titannitrid) durch Gasphasenreaktion (CVD-Prozeß) von Titantetrachlorid mit Methan und Wasserstoff bei etwa 1000°C aufgebracht werden. Die DE-OS lehrt also, eine im Vergleich zum Hartmetallgrundkörper weiche Metallunterschicht (Molybdän und/oder Wolfram) durch direkte Kathodenzerstäubung aufzubringen, um die Verschleißeigenschaften gegenüber den CVD/CVD-Verfahren mit "harter" Unterschicht zu verbessern.

Aufgabe der Erfindung ist es, die durch das bisherige PVD/CVD-Verfahren erreichten Verschleißeigenschaften der beschichteten Hartmetallkörper, namentlich für die schneidende oder spanende Bearbeitung von Werkstücken, weiter zu verbessern.

Erfindungsgemäß wird die Aufgabe dadurch gelöst, daß die Unterschicht aus einem Hartstoff, dessen Härte größer als diejenige des Hartmetallgrundkörpers ist, mittels Ionenplattierung aufgebracht wird.

Gegenstand des Anspruchs 9 ist ein nach dem erfindungsgemäßen Verfahren beschichtetes Hartmetallwerkzeug.

Gegenstand der Ansprüche 2 bis 8 sind bevorzugte Ausführungsformen des erfindungsgemäßen Verfahren und Gegenstand der Ansprüche 10 bis 16 bevorzugte Ausführungsformen von Hartmetallwerkzeugen nach dem Verfahren.

Obwohl beim erfindungsgemäßen PVD/CVD-Verfahren, wie bei den bisherigen CVD/CVD-Verfahren für die Unterschicht ein gegenüber dem Hartmetallgrundkörper härterer Hartstoff verwendet wird, werden die Verschleißeigenschaften nicht verschlechtert - wie aufgrund der schlechteren Verschleißeigenschaften der CVD/CVD-Verfahren mit "harter" Unterschicht gegenüber den PVD/CVD-Verfahren mit "weicher" Unterschicht zu erwarten wäre - sondern im Gegenteil durch das Ionenplattieren überraschenderweise erheblich verbessert.

Die erfindungsgemäß durch Ionenplattierung aufgebrachte Hartstoff-Unterschicht haftet sehr gut auf dem Werkzeug und gewährleistet ein extrem gutes Aufwachsen und eine sehr gute Haftfähigkeit der Oberschicht. Ferner schmiegt sich die ionenplattierte Hartstoff-Unterschicht sehr gut an die Werkzeugoberfläche an und erhöht hierdurch die Haftung der über ihr liegenden Schicht. Es konnte festgestellt werden, daß die ionenplattierte Hartstoff-Unterschicht beim Aufwachsen der Oberschicht mittels chemischer Bedampfung signifikant eine Bildung von Löchern (Submikrolunker) und Fehlstellen, deren Ausdehnungen ebenfalls signifikant verkleinert werden, reduziert.

Ein gutes Aufwachsen der Oberschicht der erfindungsgemäßen Beschichtung wird je nach Material der Oberschicht insbesondere bei einer Schichtdicke der Unterschicht von etwa 0,1 µm und darunter erreicht. Infolge dieser dünnen Unterschicht reduziert sich auch die gesamte Schichtdicke der Bedampfung, was wiederum zu einer Erhöhung der Haftfähigkeit der Beschichtung und zu einer Verbesserung des Schneidverhaltens sowie einer Erhöhung der Verschleißeigenschaften führt.

Elektronenmikroskopische Untersuchungen der erfindungsgemäß hergestellten Beschichtungen zeigen eine Feinststengelstruktur der ionenplattierten Unterschicht, wobei die Kristalle der Struktur im wesentlichen parallel zur Oberfläche der Unterschicht liegen und einen Querschnitt kleiner als 6·10⁻¹⁷ m² haben. Untersuchungen an der bekannten Beschichtung, bei der die Unterschicht mittels Kathodenzerstäubung aufgebrachten wurde, zeigen eine rauhe Schicht, welche Lunker und Fehlstellen enthält. Es wird angenommen, daß die guten Eigenschaften der Hartmetallwerkzeug-Beschichtung (Aufwachsen, Haftfähigkeit, Schneidverhalten, Verschleißeigenschaften) wesentlich durch die durch das erfindungsgemäße Verfahren erzeugte Feinststengelstruktur bedingt sind.

Vorzugsweise wird die ionenplattierte Unterschicht mit einer Dicke von 0,001 bis 0,1 Mikrometern aufgebracht. Damit werden Lunker vermieden. Wie aus Dünnschliffen ersichtlich war, wächst die nachfolgend aufgebrachte Oberschicht gleichmäßig auf, ohne sich, wie bei der herkömmlichen Methode, an einzelnen Komponenten bei heterogenen Materialien der Hartmetallwerkzeuge anzulagern und Ablagerungsinseln zu bilden, welche sich später unter Entstehung der obengenannten Lunker mittels Brücken verbinden.

Die (einzige) **Figur** zeigt ein einfaches Beispiel einer Vorrichtung zur Durchführung einer Ionenplattierung des erfindungsgemäßen Verfahrens, bei dem auf dem Boden **1** einer Vakuumbeschichtungskammer **2** eine Einrichtung **4** zur elektrischen Bogenverdampfung (es können mehrere vorhanden sein) angeordnet ist.

Mit der in der **Figur** dargestellten Anlage werden zwei Hartmetallwerkzeuge **5** aus z. B. Wolframkarbid mit sechs Prozent Kobalt als Hartmetall der Klasse P30 durch Verdampfen mittels einer Bogenentladung ionenplattiert. Die Beschichtungskammer **2** ist als rechteckige Kammer **2** ausgebildet, die über einen nicht dargestellten Pumpstand, der an einen Flansch **6** der Kammer **2** anschließbar ist, evakuiert wird. An einer Seitenwand **7** der Kammer **2** ist eine Ionisationskammer **8** für eine sog. Niedervoltbogenentladung angeflanscht. Als Anode für diese Entladung dient ein Verdampfungstiegel **9**, der von der Kammer **2** durch eine Isolationshülse **11** aus Isoliermaterial elektrisch getrennt ist, und mittels eines Wärmetauschers, dessen Kühlwasserein- und -auslaß **13** und **15** in der **Figur** dargestellt sind, gekühlt wird. Im Verdampfungstiegel **9** liegt ein Material **17**, welches sich nach der unten beschriebenen Verdampfung und Bildung einer chemischen Verbindung mit einem in die Kammer **2** eingelassenen Gas als Hartstoff als Unterschicht auf der Oberfläche **18** des Hartmetallgrundkörpers **5** niederschlägt. Der positive Pol **19** eines Bogenentladungsspeisegeräts **24** ist elektrisch mit dem Verdampfungstiegel **9** verbunden und der negative Pol **23** mit einer Elektrode **25** in der Ionisationskammer **8**.

Neben dem Verdampfungstiegel **9** auf der anderen Seite der Ionisationskammer **8** ist eine sog. Fernfokus-Elektronenquelle **26** auf dem Boden **1** angeordnet. Durch ein nicht dargestelltes Magnetfeld, dessen Feldlinien im wesentlichen senkrecht zur Zeichenebene verlaufen, wird ein Elektronenstrahl **28** der Quelle **26** auf das zu verdampfende Material **17** gelenkt. Die Elektronen werden auf ihrem Weg von der Quelle **26** zum Material **17** um 180° abgelenkt und gleichzeitig fokussiert.

Zwischen dem Verdampfungstiegel **9** und der Ionisationskammer **8** brennt ein nicht dargestellter Lichtbogen der Niedervoltbogenentladung. Zur Fokussierung und Führung des Lichtbogens dient das Magnetfeld einer oder mehrerer schematisch dargestellter Spulen **27**. Die Technik der Materialverdampfung, sowie die Führung und Fokussierung des Lichtbogens sind Stand der Technik und können einschlägiger Literatur entnommen werden.

Die zu beschichtenden Hartmetallgrundkörper **5** sind auf einem Drehteller **43** in der Kammer **2** befestigt. Der Drehteller **43** rotiert um eine Achse **45**, welche durch ein Zwischenstück **47** von der Kammerwand **2** isoliert ist. Die Achse 45 ist über eine elektrische Leitung **46** mit einem Spannungsgenerator **48** verbunden, um eine elektrische Vorspannung an die Hartmetallgrundkörper **5** angelegen zu können.

Der Abstand der Oberflächen **18** der Hartmetallgrundkörper **5** vom Lichtbogen ist so groß gewählt, daß die durch den brennenden Lichtbogen hervorgerufene elektrische Ionisation bezogen auf die Ionisation des Lichtbogenkerns auf einen Wert unter zwanzig Prozent abgefallen ist.

In der Ionisationskammer **8** verbindet ein Glühfaden **49** die Elektrode **25** mit einer weiteren gegenüber der Wand der Ionisationskammer **8** und der Elektrode **25** isolierten Elektrode **51**.

Über eine Gaseinfüllvorrichtung **50** in der Wand der Ionisationkammer **8** kann ein für die Entladung erforderliches Edelgas sowie ein reaktives Gas eingelassen werden.

Vor dem Aufbringen der Unterschicht mittels Ionenplattierung werden die Hartmetallgrundkörper **5** einem der bekannten Reinigungs- und Ätzverfahren unterzogen, wie z. B. in der CH-PS 664 768 beschrieben. Die Reinigung erfolgt innerhalb oder außerhalb der Kammer **2**.

Zum Aufbringen der ionenplattierten Unterschicht auf die am Drehteller **43** befestigten Hartmetallgrundkörper **5** wird Silizium als zu verdampfendes Material **17** in den Tiegel **9** gelegt. Der Niedervoltbogen wird gezündet und brennt nun vom Glühfaden **49** zum Silizium **17** im Verdampfungstiegel **9** mit einer Bogenspannung von 90 V und einem Strom von 60 A, wobei bei Erreichen des Schmelzpunktes die Spannung auf 70 V abfällt und der Strom auf 200 A aufgrund der sich mit der Temperatur erhöhenden Leitfähigkeit des Siliziums **17** ansteigt.

In einem ersten Verfahrensschritt wird die Stromstärke des Niedervoltbogens auf 200 A bei einer Bogenspannung von 70 V gehalten. Hierdurch wird Silizium **17** aus dem Verdampfungstiegel **9** in den gasförmigen Zustand überführt und teilweise ionisiert.

In einem zweiten Verfahrensschritt wird in eine beim vorhergehenden Reinigungsvorgang verwendete Argonatmosphäre Stickstoff durch die Gaseinlaßeinrichtung **50** eingelassen, der durch den Niedervoltbogen teilweise ionisiert wird. Der teilweise ionisierte Stickstoff und das teilweise ionisierte Silizium vereinigen sich auf der Oberfläche **18** der Grundkörper **5** zu Siliziumnitrid Si₃N₄ , dessen Härte größer als 2000 Vickers ist, und bleiben auf ihr haften. Damit eine gleichmäßige Schichtdicke erreicht wird, rotiert der Drehteller **43** mit einer Umdrehungszahl von ungefähr drei Umdrehungen pro Minute.

Während dieses zweiten Verfahrensschrittes beträgt der Partialdruck des Argons 4·10⁻² Pa und der des Stickstoffs 3·10⁻² Pa. An den Drehteller **43** wird über die Leitung **46** eine vom Spannungsgenerator **48** erzeugte pulsierende Gleichspannung mit einer Periodendauer von 10 µs gelegt. Zu Beginn dieses Verfahrensschrittes liefert der Spannungsgenerator **48** negative Pulse mit einer Pulsbreite von 8 µs und einer Amplitude von - 200 V. In den folgenden 2 µs ist der Drehteller **43** über den Spannungsgenerator **48** geerdet. Während dieses Verfahrensschrittes wird die Amplitude derart zu kleineren negativen Werten angehoben, daß sie gegen Ende bei - 10 V liegt.

Ist eine Schichtdicke der Unterschicht von 0,1 µm aufgebracht, wird der Niedervoltbogen abgeschaltet und der Stickstoff- und Argonzufluß unterbrochen. Man läßt die mit der Unterschicht versehenen Hartmetallgrundkörper **5** abkühlen und entnimmt sie der Kammer **2**, um in einer anderen Anlage mittels eines CVD-Prozesses eine 5 µm dicke Diamantoberschicht, nach einem Verfahren wie von Fedosayev D. V., Deryagin B. V., Varasavskaja I. G., "Crystallization of Diamond", 1984, Mauka, Moskau aufzubringen. Die in der Literatur beschriebenen Verfahren arbeiten jedoch ohne die erfindungsgemäße Hartstoffunterschicht.

Statt für die Unterschicht Si₃N₄ zu verwenden, kann auch SiO₂ oder SiₓO_{y}N_{z} verwendet werden. Die Unterschicht aus SiO₂ oder SiₓO_{y}N_{z} wird analog zu dem bereits oben geschilderten Verfahren aufgebracht. Bei Unterschichten aus SiₓO_{y}N_{z} wird mit einem Partialdruck von 3·10⁻² Pa Argon, 1·10⁻² Pa Sauerstoff und 3·10⁻² Pa Stickstoff gearbeitet.

Es kann auch eine Unterschicht aus einem Oxyd und/oder Nitrid des Aluminiums, einem Oxyd eines Elements der Gruppe IVb (Titan, Zirkon, Hafnium), Vb (Vanadium, Niob, Tantal), VIb (Chrom, Molybdän, Wolfram) oder des Chroms oder aus Mischungen dieser Stoffe oder Mischungen dieser Stoffe mit einem Oxyd, Nitrid oder Oxynitrids des Siliziums erfolgen.

Das Material der Unterschicht kann ferner mit einem Elektronenstrahl, durch eine plasmaunterstütze Verdampfung oder eine kathodische Bogenverdampfung in den gasförmigen Zustand überführt werden. Die Bogenentladung kann neben den Niedervoltbogen mit einem heißen Filament, mit Funkenverdampfung oder Hohlkathode arbeiten.

Anstatt den Niedervoltbogen nur zur Ionisierung zu verwenden, kann seine Stromstärke so eingestellt werden, daß sie auch zum Verdampfen des Materials ausreicht. Durch die Führung und Fokussierung des Lichtbogens mittels magnetischer Felder kann bei gleicher Verdampfungs- und Ionisationsrate gegenüber einem Arbeiten ohne Magnetfelder die Stromstärke des Bogens so reduziert werden, daß Materialspritzer auf der Oberfläche des Hartmetallgrundkörpers **5** vermieden werden.

Statt den Tiegel als eine der Elektroden des Lichtbogens zu verwenden, kann eine zweite Elektrode in einer horizontalen Ebene unterhalb des Drehtellers **43** in der auch die andere Elektrode liegt, sich befinden. Der Lichtbogen brennt dann über dem Tiegel **9** und ionisiert das mittels einem der obigen Verfahren aus dem Tiegel **9** verdampfte Material.

Statt das Material **17** im Verdampfungstiegel **9** mit einem Elektronenstrahl **28** zu verdampfen, kann es auch thermisch verdampft werden.

Die Auswahl eines der oben genannten Verfahren zur Ionenplattierung ist nicht beliebig, sondern richtet sich nach den Materialen, welche für die Ionenplattierung verwendet werden sollen.

Nachfolgend werden der Vollständigkeit halber noch einige in der Beschreibung verwendete Fachausdrücke erläutert:

### CVD-Prozeß

Bei einem CVD-Prozeß (chemical vapor deposition) reagieren in die Beschichtungskammer eingeleitete Gase bei erhöhter Temperatur unter Abscheidung auf einem zu beschichtenden heißen Grundkörper miteinander.

### PVD-Prozeß

Unter einem PVD-Prozeß (physical vapor deposition) wird eine Beschichtung verstanden, bei der wenigstens eine, jedoch immer die metallische Komponente durch Verdampfen oder Zerstäuben in der Beschichtungskammer in deren Gasphase eingebracht wird.

### Direkte Kathodenzerstäubung

Bei der direkten Kathodenzerstäubung (PVD), auch Sputtern genannt, schlagen bei einer Glimmentladung die auf das Material einer Kathode auftreffenden Ionen Material heraus, welches auf der Oberfläche des zu beschichtenden Grundkörpers niedergeschlagen wird.

### Reaktive Kathodenzerstäubung

Die reaktive Kathodenzerstäubung (PVD) erfolgt analog zur direkten Kathodenzerstäubung, jedoch reagiert hier das herausgeschlagene Material auf der Oberfläche des zu beschichtenden Grundkörpers mit einem in die Vakuumbeschichtungskammer eingelassenen Gas oder Gasgemisch.

### Ionenplattierung

Bei der Ionenplattierung (PVD) wird ein Metall im Hochvakuum mittels Bogenentladung verdampft oder ionisiert bevor es auf dem Grundkörper niedergeschlagen wird. Auch hier kann in die Beschichtungskammer ein reaktives Gas oder Gasgemisch eingelassen werden, welches mit dem verdampften Material auf der zu beschichtenden Oberfläche des Grundkörpers eine chemische Verbindung eingeht.

### Hartstoffe

Hartstoffe sind keramische, elektrisch nicht leitende Materialien aus Karbiden, Nitriden, Boriden, Siliziden, Oxyden und/oder Oxynitriden, die eine besonders große Härte besitzen und die einen hohen Schmelzpunkt haben, wie z. B. Siliziumnitrid, Titankarbid, Titannitrid, Titankarbonitrid, Siliziumoxyd, Siliziumoxynitrid, etc.

### Hartmetall

Hartmetalle werden im Gießverfahren oder pulvermetallurgischen Verfahren hergestellt und bestehen aus einer Bindemetallphase, die aus Legierungen des Eisens, Kobalts und/oder Nickels zusammengesetzt ist, und aus einer Hartstoffphase, die vorzugsweise harte Karbide des Wolframs, Titans, Niobs und/oder Tantals enthält.

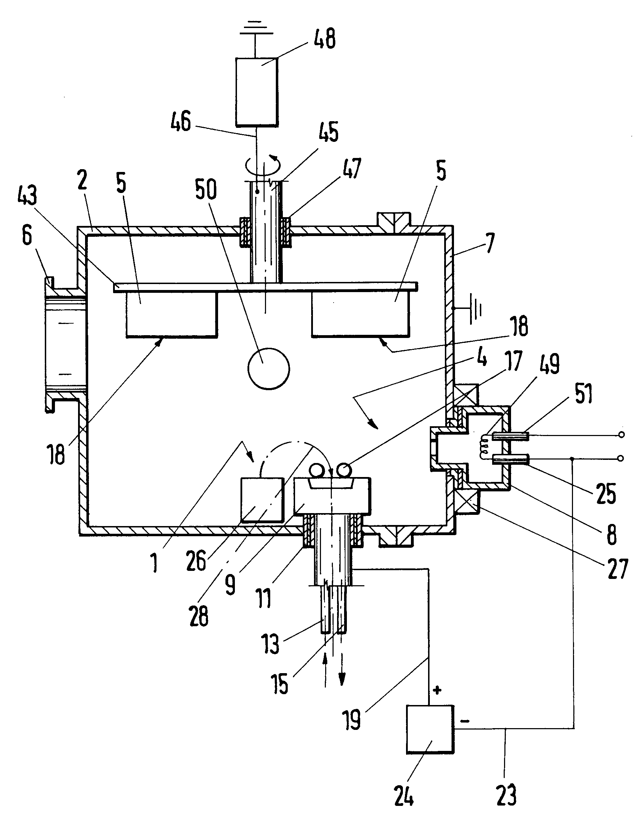

## Patentansprüche

1. Verfahren zur Beschichtung von Hartmetallgrundkörpern **(5)**, insbesondere zur Verwendung als Schneid- oder Trennwerkzeug, bei dem zuerst eine Unterschicht durch einen PVD-Prozeß unmittelbar auf den oder die zu beschichtenden Bereiche der Grundkörperoberfläche **(18)** und anschließend eine Oberschicht aus einem Hartstoff durch einen CVD-Prozeß auf wenigstens einen Teil der Unterschicht aufgebracht wird, **dadurch gekennzeichnet**, daß die Unterschicht aus einem Hartstoff, dessen Härte größer als diejenige des Hartmetallgrundkörpers ist, mittels Ionenplattierung aufgebracht wird.

2. Verfahren nach Anspruch 1, **dadurch gekennzeichnet**, daß die Oberschicht aus einem anderen Hartstoff, dessen Härte größer als diejenige des Hartstoffs der Unterschicht ist, aufgebracht wird.

3. Verfahren nach Anspruch 1 oder 2, **dadurch gekennzeichnet**, daß als Unterschicht ein Hartstoffmaterial dessen Härte größer als 2000 Vickers ist, verwendet wird.

4. Verfahren nach einem der Ansprüche 1 bis 3, **dadurch gekennzeichnet**, daß der Hartstoff der Unterschicht aus einer Hartstoffverbindung des Siliziums, z. B. Siliziumnitrid besteht.

5. Verfahren nach einem der Ansprüche 1 bis 4, **dadurch gekennzeichnet**, daß der Hartstoff der Oberschicht aus Diamant besteht.

6. Verfahren nach einem der Ansprüche 1 bis 5, **dadurch gekennzeichnet**, daß die Unterschicht in einer Dicke von höchstens etwa 0,1 Mikrometer, vorzugsweise weniger als 0,1 Mikrometer ionenplattiert wird, wodurch die Kondensationskinetik der die Oberschicht bildenden Reaktion der verschiedenen katalytischen Aktivitäten der Komponenten des Materials des Grundkörpers **(5)** ausgeglichen und die Bildung von Submikrolunkern in der Oberschicht vermieden wird.

7. Verfahren nach einem der Ansprüche 1 bis 6, **dadurch gekennzeichnet**, daß zur Durchführung der Ionenplattierung ein Lichtbogen zwischen zwei Elektroden erzeugt wird, wobei eine der Elektroden oder beide mindestens im Auftreffbereich des Lichtbogens aus dem Material oder mindestens einer der Materialkomponenten der herzustellenden Unterschicht bestehen oder dieses bzw. diese enthalten, und der oder die Grundkörper **(5)** an einem Ort angeordnet werden, an dem die durch den Lichtbogen hervorgerufene elektrische Ionisierung bezogen auf die Ionisierung des Bogenkerns unter einen Wert von sechzig Prozent, bevorzugt unter zwanzig Prozent abgefallen ist.

8. Verfahren nach einem der Ansprüche 1 bis 7, **dadurch gekennzeichnet**, daß die Oberschicht mit einer Schichtdicke größer als 3 µm erzeugt wird.

9. Hartmetallwerkzeug, insbesondere Schneid- oder Trennwerkzeug, beschichtet nach dem Verfahren gemäß einem der Ansprüche 1 bis 8, **gekennzeichnet durch** eine unmittelbar auf der Grundkörperoberfläche **(18)** liegende, mittels Ionenplattierung erzeugte Hartstoffunterschicht, deren Hartstoff härter als das Material des Hartmetallgrundkörpers ist, und eine auf dieser liegende, mittels chemischer Bedampfung (CVD) erzeugte weitere Hartstoffschicht als Oberschicht.

10. Hartmetallwerkzeug nach Anspruch 9, **dadurch gekennzeichnet**, daß der Hartstoff der Unterschicht härter als 2000 Vickers ist.

11. Hartmetallwerkzeug nach Anspruch 9 oder 10, **dadurch gekennzeichnet**, daß der Hartstoff der Oberschicht härter als derjenige der Unterschicht ist.

12. Hartmetallwerkzeug nach einem der Ansprüche 9 bis 11, **dadurch gekennzeichnet**, daß die ionenplattierte Unterschicht eine Dicke von höchstens etwa 0,1 Mikrometer, vorzugsweise weniger als 0,1 Mikrometer hat.

13. Hartmetallwerkzeug nach einem der Ansprüche 9 bis 12, **dadurch gekennzeichnet**, daß die ionenplattierte Unterschicht eine Feinststengelstruktur hat, wobei die Kristalle der Struktur im wesentlichen parallel zur Oberfläche der Unterschicht liegen und einen Querschnitt kleiner als 6·10⁻¹⁷ m² haben.

14. Hartmetallwerkzeug nach einem der Ansprüche 9 bis 13, **dadurch gekennzeichnet**, daß die Oberschicht dicker als 3 µm ist.

15. Hartmetallwerkzeug nach einem der Ansprüche 9 bis 13, **dadurch gekennzeichnet**, daß die Unterschicht im wesentlichen aus einer Hartstoffverbindung des Siliziums, z. B. Siliziumnitrid besteht.

16. Hartmetallwerkzeug nach Anspruch 15, **dadurch gekennzeichnet**, daß die Oberschicht aus Diamant besteht.

## Claims

1. Process for coating hard-metal base substances (5), especially for use as a cutting or parting tool, in which first an undercoat is applied directly to the area or areas of the surface (18) of the base substances to be coated by a PVD-process, and then a topcoat of a hard substance is applied to at least a portion of the undercoat by a CVD-process, characterised in that the undercoat is of a hard substance, the hardness of which is greater than that of the hard-metal base substance, applied by means of ion-plating.

2. Process according to Claim 1, characterised in that the topcoat is of another hard substance, the hardness of which is greater than that of the hard substance of the undercoat.

3. Process according to Claim 1 or 2, characterised in that a hard substance, the hardness of which is greater than 2000 Vickers, is used as the undercoat.

4. Process according to one of Claims 1 to 3, characterised in that the hard substance of the undercoat consists of a hard silicon compound, e.g. silicon nitride.

5. Process according to one of Claims 1 to 4, characterised in that the hard substance of the topcoat consists of diamond.

6. Process according to one of Claims 1 to 5, characterised in that the undercoat is ion-plated to a thickness of around 0.1 micrometers at most, preferably of less than 0.1 micrometers, whereby during the reaction which forms the topcoat the condensation effect due to the various catalytic activities of the constituents of the base material (5) is equalized and the formation of sub-micro cavities in the topcoat is avoided.

7. Process according to one of Claims 1 to 6, characterised in that the ion-plating is effected by producing an electric arc between two electrodes, whereof one or both of the electrodes, at least in the area of impact of the electric arc, consist of the material, or at least one of the constituents, of the undercoat which is to be produced, or contain said material or constituents, and in that the base substance or substances (5) are placed at a position where the electrical ionization generated by the electric arc has fallen to below a value of sixty per cent, and preferably to below twenty per cent, of the ionization at the core of the arc.

8. Process according to one of Claims 1 to 7, characterised in that the topcoat is formed with a layer thickness greater than 3 µm.

9. Hard-metal tool, especially a cutting or parting tool, coated according to the process described in one of Claims 1 to 8, characterised in that it has an undercoat of a hard substance applied to the surface (18) of the base substance directly and produced by ion-plating, the hard substance of which is harder than the material of the hard-metal base substance, and a further layer of a hard substance as a topcoat, applied to the undercoat and produced by chemical vapour-deposition (CVD).

10. Hard-metal tool according to Claim 9, characterised in that the hard substance of the undercoat is harder than 2000 Vickers.

11. Hard-metal tool according to Claim 9 or 10, characterised in that the hard substance of the topcoat is harder than that of the undercoat.

12. Hard-metal tool according to one of Claims 9 to 11, characterised in that the ion-plated undercoat has a thickness of around 0.1 micrometers at most, preferably of less than 0.1 micrometers.

13. Hard-metal tool according to one of Claims 9 to 12, characterised in that the ion-plated undercoat has a fine rod structure, in which the crystals of the structure lie essentially parallel to the surface of the undercoat and have a cross-section smaller than 6 x 10⁻¹⁷ m².

14. Hard-metal tool according to one of Claims 9 to 13, characterised in that the topcoat is thicker than 3 µm.

15. Hard-metal tool according to one of Claims 9 to 13, characterised in that the undercoat consists essentially of a hard silicon compound, e.g. silicon nitride.

16. Hard-metal tool according to Claim 15, characterised in that the topcoat consists of diamond.

## Revendications

1. Procédé pour le revêtement de substrats en métal dur (5) notamment pour l'utilisation en tant qu'outil de coupe ou de séparation, dans lequel on applique d'abord une sous-couche par procédé PVD (déposition en phase gazeuse par procédé physique) directement sur la ou les zones à revêtir de la surface (18) du substrat et consécutivement une couche supérieure à partir d'une matière dure par un procédé CVD (déposition en phase gazeuse par procédé chimique) sur au moins une partie de la couche inférieure, caractérisé en ce que la couche inférieure est en matériau à résistance mécanique élevée dont la dureté est supérieure à celle du substrat en métal dur, par placage ionique.

2. Procédé selon la revendication 1, caractérisé en ce que l'on applique la couche supérieure à partir d'un autre matériau à résistance mécanique élevée dont la dureté est supérieure à celle du matériau à résistance mécanique élevée de la sous-couche.

3. Procédé selon la revendication 1 ou 2, caractérisé en ce que en tant que sous-couche, on fait appel à un matériau à résistance mécanique élevée dont la dureté est supérieure à 2000 Vickers.

4. Procédé selon l'une des revendications 1 à 3, caractérisé en ce que le matériau à résistance mécanique élevée de la sous-couche consiste en un composé de substance dure de silicium, par exemple de nitrure de silicium.

5. Procédé selon l'une des revendications 1 à 4, caractérisé en ce que le matériau à résistance mécanique élevée de la couche supérieure consiste en un diamant.

6. Procédé selon l'une des revendications 1 à 5, caractérisé en ce que la sous-couche est plaquée ioniquement sur une épaisseur de maximum environ 0,1 micromètre, de préférence inférieure à 0,1 micromètre, ce en quoi on équilibre la cinétique de condensation de la réaction formant la couche supérieure des différentes activités catalytiques des composants du matériau du substrat (5) et l'on évite la formation de piqûres sous-microniques dans la couche supérieure.

7. Procédé selon l'une des revendications 1 à 6, caractérisé en ce que pour la réalisation du placage ionique, on produit un arc électrique entre deux électrodes, l'une des électrodes ou les deux électrodes consistant ou contenant dans la zone d'incidence de l'arc électrique le matériau ou au moins l'un des composants de matériau de la sous-couche à produire et qui est ou sont appliquées sur le substrat (5) en un emplacement où l'ionisation électrique provoquée par l'arc électrique rapportée à l'ionisation du noyau de l'arc chute sous une valeur de 60 %, de préférence sous une valeur de 20 %.

8. Procédé selon l'une des revendications 1 à 7, caractérisé en ce que la couche supérieure est produite sur une épaisseur de couche supérieure à 3 µm.

9. Outil en métal dur, notamment outil de coupe ou de séparation, revêtu selon le procédé de l'une des revendications 1 à 8, caractérisé par une sous-couche en matériau à résistance mécanique élevée produit par placage ionique directement sur la surface (18) du substrat, dont le matériau à résistance mécanique élevée est plus dur que le matériau du substrat en métal dur et une autre couche en matériau à résistance mécanique élevée appliquée sur celui-ci au moyen de la vaporisation chimique (CVD) en tant que couche supérieure.

10. Outil en métal dur selon la revendication 9, caractérisé en ce que le matériau à résistance mécanique élevée de la sous-couche est d'une dureté supérieure à 2000 Vickers.

11. Outil en métal dur selon la revendication 9 ou 10, caractérisé en ce que le métal dur de la couche supérieure est plus dur que celui de la couche inférieure.

12. Outil en métal dur selon l'une des revendications 9 à 11, caractérisé en ce que la sous-couche obtenue par placage ionique a une épaisseur au plus d'environ 0,1 micromètre, de préférence inférieure à 0,1 micromètre.

13. Outil en métal dur selon l'une des revendications 9 à 12, caractérisé en ce que la sous-couche obtenue par placage ionique a une structure basaltique ultrafine, les cristaux de la structure se situant essentiellement parallèlement à la surface de la couche supérieure et présentent une section transversale inférieure à 6.10⁻¹⁷ m².

14. Outil en métal dur selon l'une des revendications 9 à 13, caractérisé en ce que la couche supérieure est d'une épaisseur supérieure à 3 µm.

15. Outil en métal dur selon l'une des revendications 9 à 13, caractérisé en ce que la sous-couche consiste essentiellement en un composé de matériau à résistance mécanique élevée du silicium, par exemple du nitrure de silicium.

16. Outil en métal dur selon la revendication 15, caractérisé en ce que la couche supérieure est constituée par du diamant.
